# EUROPÄISCHE PATENTSCHRIFT

(11) **EP 3 057 231 B1**
(45) Veröffentlichungstag und Bekanntmachung des Hinweises auf die Patenterteilung: **10.04.2019**
(21) Anmeldenummer: 15155262.7
(22) Anmeldetag: 16.02.2015
(51) Int. Cl.: H03K 17/0412, H03K 17/16

(54) **Steuerschaltung und Steuerverfahren zum Anschalten eines Leistungshalbleiterschalters**
Control circuit and control method for activating a power semiconductor switch
Circuit de commande et procédé de commande destiné à commuter un interrupteur semi-conducteur de puissance

(43) Veröffentlichungstag der Anmeldung: 17.08.2016
(73) Patentinhaber: Power Integrations Switzerland GmbH, 2504 Biel-Bienne (CH)
(72) Erfinder: Siebler, Matthias, 2504 Biel-Bienne (CH)
(74) Vertreter: Conroy, John

(56) Entgegenhaltungen:
- EP-A1- 1 906 532
- EP-A1- 2 587 670
- GB-A- 2 417 149
- US-A1- 2007 103 133
- US-A1- 2009 027 096

## Beschreibung

### TECHNISCHES GEBIET

Um das Schaltverhalten von Leistungshalbleiterschaltern (wie zum Beispiel IGBTs) zu verbessern, setzen Steuerschaltungen des Stands der Technik externe Widerstände ein. Diese werden während eines Einschaltvorgangs an den Steuereinschluss des Leistungshalbleiterschalters gekoppelt, so dass ein Einschaltstrom in den Steuereingang fließen kann, um den Leistungshalbleiterschalter einzuschalten. Die externen Widerstände können in manchen Beispielen einen Widerstand von 8 Ω oder mehr aufweisen, was in bestimmten Situationen gewisse Verluste erzeugen kann.

US 2007/0103133 beschreibt ein Verfahren zum Auslösen eines Lastelements unter Verwendung eines elektronischen Schaltelementes, bei dem die Spannung am Lastelement mit einer maximal vorgegebenen Erhöhung gesteuert wird.

EP 2587670 A1 beschreibt ein Steuerkontakt-Ansteuersystem für eine Vielzahl von Leistungshalbleiterbauelementen.

GB 2417149 A beschreibt ein Verfahren zum Betreiben eines elektronischen Ventils.

### ZUSAMMENFASSUNG DER ERFINDUNG

Eine Vorrichtung und ein Verfahren gemäß der Erfindung werden in den beigefügten Ansprüchen definiert.

Durch die Verwendung einer variablen Stromquelle kann die Steuerschaltung eine variable Transkonduktanz aufweisen. Das kann hilfreich sein, um verschiedene Parameter der Schaltung zu optimieren (beispielsweise, um Verluste während des Einschaltvorgangs zu reduzieren). Ähnliches gilt für die Steuerung der variablen Stromquelle in einem geschlossenen Regelkreis. Des Weiteren kann eine variable Stromquelle in manchen Bespielen eine höhere Stabilität gegenüber herstellungsbedingten Schwankungen und Temperaturschwankungen aufweisen als eine Schaltung mit externen Widerständen. Die Detektion von Phasen anhand eines Signals, das das Einschaltverhalten des Leistungshalbleiterschalters charakterisiert, kann mit relativ geringem schaltungstechnischen Aufwand erfolgen (insbesondere, wenn eine Steuereingangsspannung verwendet wird). Das kann die Komplexität und damit den Preis der Steuerschaltung reduzieren. Des Weiteren können, in manchen Bespielen, die Steuerschaltungen mit einer Phasendetektionsschaltung relativ einfach an verschiedene Leistungshalbleiterschalter angepasst werden. Zudem kann in manchen Beispielen bei Leistungshalbleiterschaltern mit mittlerer oder hoher Gate-Ladung die Ansprechzeit verkürzt werden.

### KURZBESCHREIBUNG DER FIGUREN

Nicht-limitierende und nicht-erschöpfende Ausführungsbeispiele der Erfindung sind bezugnehmend auf die folgenden Figuren beschrieben, wobei gleiche Referenzzeichen sich auf gleiche Komponenten in den verschiedenen Figuren beziehen, soweit nichts Anderes spezifiziert ist.
**Figur 1** zeigt eine beispielhafte Steuerschaltung mit einer variablen Stromquelle und einer Phasendetektionsschaltung.
**Figur 2** zeigt beispielhafte Signalverläufe in einem IGBT-Treiber, der eine Steuerschaltung mit einer variablen Stromquelle und einer Phasendetektionsschaltung umfasst.
**Figur 3** zeigt eine beispielhafte variable Stromquelle und eine Phasendetektionsschaltung.
**Figur 4** zeigt ein Zustandsdiagramm einer beispielhaften Steuerschaltung.
**Figur 5** zeigt eine beispielhafte Phasendetektionsschaltung, die eine Kollektor-Emitter-Spannung eines Leistungshalbleiterschalters zur Phasendetektion verwendet.

### DETAILLIERTE BESCHREIBUNG

In der folgenden Beschreibung werden zahlreiche Details aufgeführt, um ein tiefgreifendes Verständnis der vorliegenden Erfindung zu ermöglichen. Es ist dem Fachmann jedoch klar, dass die spezifischen Details nicht notwendig sind, um die vorliegende Erfindung umzusetzen. An anderer Stelle sind bekannte Vorrichtungen und Verfahren nicht detailliert geschildert, um das Verständnis der vorliegenden Erfindung nicht unnötig zu erschweren.

In der vorliegenden Beschreibung bedeutet eine Bezugnahme auf "eine Ausführung", "einer Ausgestaltung", "ein Beispiel" oder "Beispiel", dass ein bestimmtes Merkmal, eine Struktur oder Eigenschaft, die in Verbindung mit dieser Ausführungsform beschrieben ist, in mindestens einer Ausführungsform der vorliegenden Erfindung beinhaltet ist. So beziehen sich die Phrasen "in einer Ausführung", "in einer Ausführungsform", "ein Beispiel" oder "in einem Beispiel" an verschiedenen Stellen in dieser Beschreibung nicht unbedingt alle auf dieselbe Ausführungsform oder dasselbe Beispiel. Ferner können die bestimmten Merkmale, Strukturen oder Eigenschaften in beliebigen geeigneten Kombinationen und / oder Unterkombinationen in einer oder mehreren Ausführungsformen oder Beispielen kombiniert werden. Besonderen Merkmale, Strukturen oder Eigenschaften können in einer integrierten Schaltung, in einer elektronischen Schaltung, in einer Schaltungslogik oder in anderen geeigneten Komponenten beinhaltet sein, die die beschriebene Funktionalität bereitstellen. Darüber hinaus wird darauf hingewiesen, dass die Zeichnungen zum Zwecke der Erläuterung für den Fachmann dienen und dass die Zeichnungen nicht notwendigerweise maßstabsgetreu gezeichnet sind.

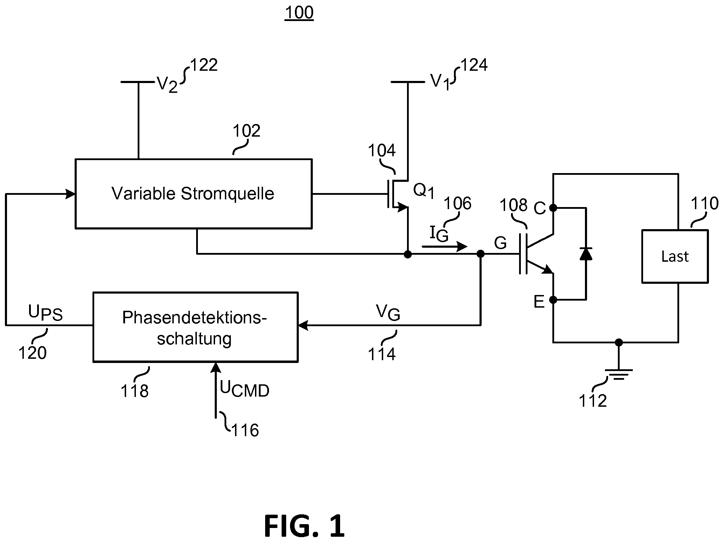

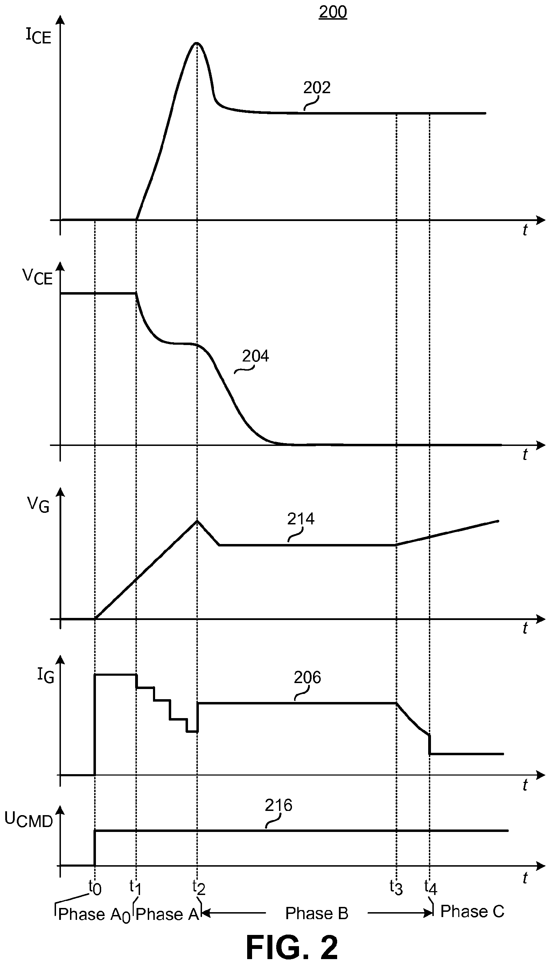

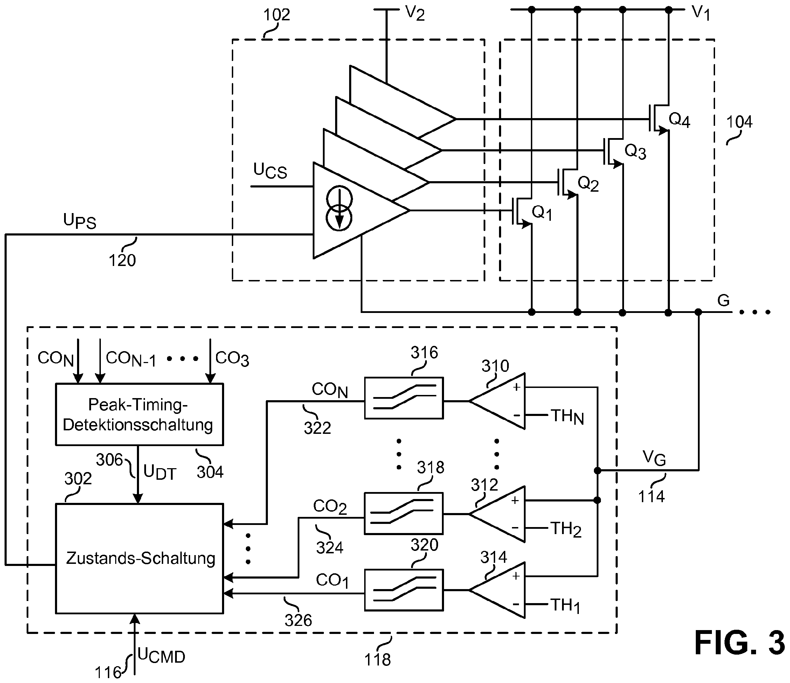

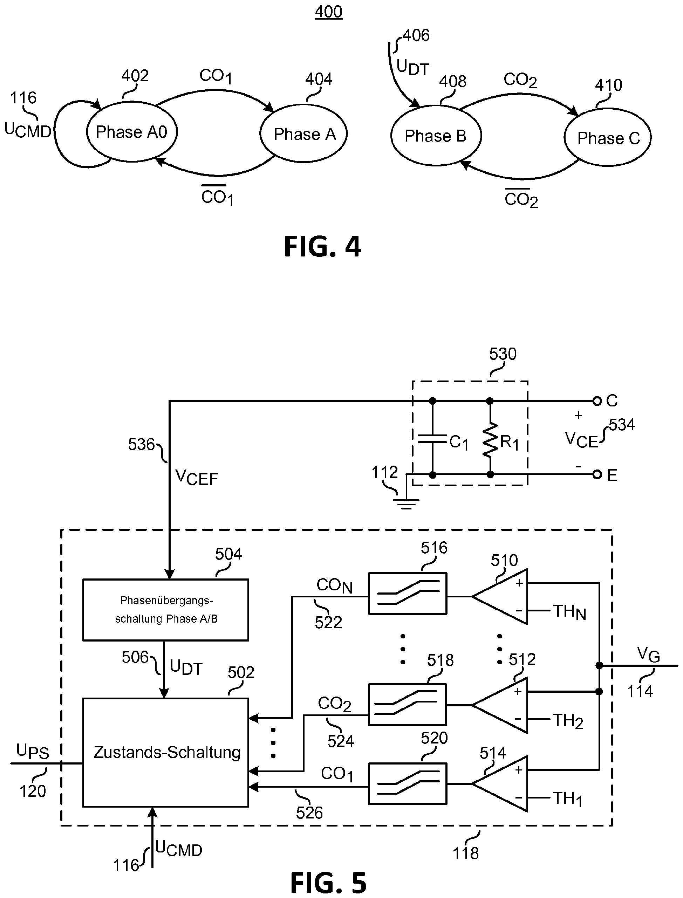

Zunächst wird ein schematischer Aufbau einer beispielhaften Steuerschaltung anhand von **Fig. 1** erläutert. Im Zusammenhand mit **Fig. 2** werden dann beispielhafte Signalverläufe in einer Schaltung besprochen, die eine beispielhafte Steuerschaltung umfasst. Im Weiteren werden beispielhafte Ausgestaltungen und optionale Komponenten der Steuerschaltung diskutiert. **Fig. 3** und **Fig. 5** zeigen solche beispielhaften Ausgestaltungen.

Zunächst sollen anhand von **Fig. 1** die Funktionen der Elemente einer beispielhaften Steuerschaltung 100 besprochen werden. **Fig. 1** zeigt eine beispielhafte Steuerschaltung 100 für einen Leistungshalbeliterschalter 108. Die Steuerschaltung 100 der **Fig. 1** ist dazu ausgelegt, einen Einschaltvorgang des Leistungshalbleiterschalters 108 zu steuern, indem sie einen variablen Strom an den Steuereingang des Halbleiterschalters 108 liefert. Im Weiteren wird lediglich eine Steuerung des Einschaltvorgangs diskutiert. Allerdings können die hierin offenbarten Steuerschaltungen auch zur Steuerung des Abschaltvorgangs eines Leistungshalbeiterschalters verwendet werden (insbesondere Steuerschaltungen, die eine variable Stromquelle und eine Phasendetektionsschaltung umfassen). Im Allgemeinen führt ein Abschaltvorgang einen Halbleiterschalter von einem eingeschalteten Zustand ("AN-Zustand") in einen ausgeschalteten Zustand (AUS-Zustand). Dabei fließt im angeschalteten Zustand ein Strom während im ausgeschalteten Zustand kein Strom fließt.

Wie in **Fig. 1** zu sehen, hat der Leistungshalbleiterschalter 108 einen Steuereingang G, sowie zwei weiter Eingänge C, E, wobei der Strom durch und/oder die Spannung zwischen den weiteren Eingänge C, E durch ein Signal am Steuereingang G gesteuert wird.

In der Folge werden die Vorrichtungen und Verfahren am Beispiel von IGBTs erläutert. Allerdings sind die Steuerschaltungen und Steuerverfahren nicht auf den Einsatz mit IGBTs beschränkt. Vielmehr können sie auch in Kombination mit anderen Leistungshalbleiterschaltern verwendet werden. Zum Beispiel können Metall-Oxid-Halbleiter-Feldeffekttransistor (MOSFETs), Bipolartransistoren, IEGTs ("injection enhancement gate transistors") und GTOs ("gate turn-off thyristors") mit den Steuerschaltungen verwendet werden. Auch können die Vorrichtungen zur Detektion eines Verlaufs einer Spannung über einem Leistungshalbleiterschalter, die Steuerschaltungen und die Vorrichtungen zur Bereitstellung von elektrischer Energie mit Leistungshalbleiterschaltern verwendet werden, die auf Galliumnitrid-(GaN)-Halbleitern oder Siliziumkarbid-(SiC)-Halbleitern basieren.

Eine maximale nominale Kollektor-Emitter-, Anoden-Kathoden oder Drain-Source-Spannung eines Leistungshalbleiterschalters im ausgeschalteten Zustand kann mehr als 500 V, bevorzugt mehr als 2 kV, betragen.

Zudem sind die Steuerschaltungen nicht auf Leistungshalbleiterschalter beschränkt. So können auch andere Halbleiterschalter mit den Steuerschaltungen verwendet werden. Die Effekte und Vorteile, die hier besprochen werden, treten zumindest teilweise auch in Systemen mit anderen Halbleiterschaltern auf.

Da in der Folge IGBTs diskutiert werden, werden die Anschlüsse des Leistungshalbleiterschalters als "Kollektor", "Gate" und, "Emitter" bezeichnet. Wir bereits oben erläutert, sind die Vorrichtungen und Verfahren jedoch nicht auf IGBTs beschränkt. Um unnötige Längen zu vermeiden, umfasst die Bezeichnung "Emitter" hierin auch den mit "Source" oder "Kathode" bezeichneten Anschluss entsprechender Leistungshalbleiterschalter. Gleichermaßen umfasst der Begriff "Kollektor" hierin auch den mit "Drain" oder "Anode" bezeichneten Anschluss und der Begriff "Gate" den mit "Basis" bezeichneten Anschluss entsprechender Leistungshalbleiterschalter. In der Folge umfasst der Begriff "Kollektor-Emitter-Spannung" auch eine "Drain-Source-Spannung" und eine "Kathoden-Anoden-Spannung" und die Begriffe "Kollektor- Spannung" und "Emitter-Spannung" auch eine "Drain-Spannung" oder "Anoden-Spannung" beziehungsweise eine "Source-Spannung" oder "Kathoden-Spannung".

Die Steuerschaltung der **Fig. 1** umfasst eine variable Stromquelle 102, 104 und eine Phasendetektionsschaltung 118. Die variable Stromquelle 102, 104 ist dazu ausgelegt, in Antwort auf ein Phasensignal (U_{PS}) 120 einen variablen Strom (I_{G}) 106 an den Steuereingang G des Leistungshalbleiterschalters 108 anzulegen, um den Leistungshalbleiterschalter 108 einzuschalten. Dabei kann der variable Strom (I_{G}) 106 im Verlauf des Einschaltvorgangs zwei oder mehr (zum Beispiel mehr als fünf) diskrete Werte annehmen (ein beispielhafter Verlauf des variablen Stroms ist in der vierten Kurve von oben in **Fig. 2** gezeigt). In anderen Beispielen variiert die variable Stromquelle 102, 104 den variablen Strom (I_{G}) 106 kontinuierlich.

Im Beispiel der **Fig. 1** umfasst die variable Stromquelle 102, 104 eine Stromquellen-Schaltung 102 sowie eine Mehrzahl von Halbleiterschaltern (Q₁) 104. Die Leistungsanschlüsse der Mehrzahl von Halbleiterschaltern (Q₁) 104 ist parallel zwischen eine erste Referenzspannung (V1) 124 und den Steueranschluss G des Halbleiterschalters 108 geschaltet. Somit kann die Mehrzahl von Halbleiterschaltern (Q1) 104 einen variablen Strom in den Steueranschluss G des Leistungshalbleiterschalters leiten. Beispielsweise können nur ein Teil der Mehrzahl der Halbleiterschalter 104 in einem AN-Zustand sein und so einen vorbestimmten Strom in den Steueranschluss G leiten. Alternativ oder zusätzlich können die Halbleiterschalter ausgewählt sein, um verschieden große Ströme zu führen (zum Beispiel durch eine variable Dimensionierung der Halbleiterschalter). In dem Beispiel der Fig. 1 sind die Mehrzahl der Halbleiterschalter 104 MOSFETs. In anderen Beispielen können andere Halbleiterschalter gewählt werden.

Neben der Mehrzahl der Halbleiterschalter 104 umfasst die variable Stromquelle der **Fig. 1** die Stromquellen-Schaltung 102. Diese Stromquellen-Schaltung 102 ist dazu ausgelegt, das Phasensignal (U_{PS}) 120 zu empfangen und in Antwort auf dieses Signal die Mehrzahl der Halbleiterschalter 104 so zu schalten, dass in Abhängigkeit von jeweiligen Phase des Einschaltvorgangs des Leistungshalbleiterschalters ein Strom mit bestimmten Pegel an den Steueranschluss G geliefert wird. Eine beispielhafte variable Stromquelle 102, 104 wird weiter unten im Zusammenhang mit **Fig. 3** diskutiert werden.

Das Phasensignal (U_{PS}) 120 wird durch die Phasendetektionsschaltung 118 erzeugt. Im Beispiel von **Fig. 1** empfängt die Phasendetektionsschaltung 118 die Steuerspannung (V_{G}) 114, die an dem Steuereingang G des Leistungshalbleiterschalters 108 anliegt. Anhand des Verlaufs dieser Spannung kann die Phasendetektionsschaltung 118 bestimmen, in welcher Phase des Einschaltvorgangs sich der Leistungshalbleiterschalter befindet und ein entsprechendes Phasensignal (U_{PS}) 120 generieren. Das Verwenden der Steuerspannung (V_{G}) 114 (also der Gate-Emitter-Spannung im Falle eines IGBT) zur Detektion der Phase des Einschaltvorgangs kann in manchen Schaltungen Vorteile haben. Zum einen enthält die Steuerspannung Informationen bezüglich der Phase des Einschaltvorgangs. Zudem kann Steuerspannung leichter detektiert werden als andere Signale in der Steuerschaltung. So müsste beispielsweise eine Hochspannung (zum Beispiel die Kollektor-Emitter-Spannung) unter Umständen erst auf einen niedrigeren Spannungspegel gebracht werden. Das kann mit einem gewissen Schaltungsaufwand verbunden sein. Gleiches gilt für einen Arbeitsstrom (zum Beispiel einen Kollektor-Emitter-Strom) des Leistungshalbleiterschalters. Trotzdem kann in anderen Beispielen auch eine Spannung über die Hochspannungseingänge (zum Beispiel die Kollektor-Emitter-Spannung) oder ein Arbeitsstrom (zum Beispiel ein Kollektor-Emitter-Strom) als Detektionssignal zur Phasendetektion verwendet werden. Auch diese Signale enthalten die benötigten Informationen bezüglich der Phasen des Einschaltvorgangs.

Die Phasendetektionsschaltung 118 kann des Weiteren einen Eingang umfassen, der ein Steuersignal (U_{CMD}) 116 für den Leistungshalbleiterschalters empfangen kann. Dieses Steuersignal (U_{CMD}) 116 kann zum Beispiel einen ersten Pegel haben, wenn der Leistungshalbleiterschalter angeschaltet sein soll und einen zweiten Pegel, wenn der Leistungshalbleiterschalter ausgeschaltet sein soll. Somit kann eine Flanke in dem Steuersignal (U_{CMD}) 116 signalisieren, dass der Leistungshalbleiterschalter geschaltet werden soll. Die Phasendetektionsschaltung 118 kann anhand des Steuersignals (U_{CMD}) 116 detektieren, wann ein Einschaltvorgang des Leistungshalbleiterschalters beginnt. Dieser Zeitpunkt kann gleichzeitig der Beginn einer ersten Phase des Einschaltvorgangs sein (in dem die variable Stromquelle einen Strom mit einem ersten Pegel an den Steuereingang G liefert).

Die Steuerschaltung der **Fig. 1** bildet einen geschlossenen Regelkreis zur Steuerung des Einschaltvorgangs des Leistungshalbleiterschalters 108. Die Regelgröße ist der an den Steuereingang G gelieferte Strom. Die Messgröße ist im Fall von **Fig. 1** die Spannung am Steuereingang (V_{G}). Aus dieser Steuerspannung wird eine aktuelle Phase des Einschaltvorgangs bestimmt. Abhängig von der Phase, in der sich der Leistungshalbleiterschalter gerade befindet, wählt die Steuerschaltung wiederum einen festen oder variablen Strom aus. Dieser jeweilige Strom wird an den Steuereingang des Leistungshalbleiterschalters geliefert (was den Regelkreis "schließt"). Viele Steuerschaltungen des Stands der Technik verwenden eine Steuerung ohne Feedback (d.h. einen offenen Regelkreis). Die Steuerschaltung der **Fig. 1** kann gegenüber diesen Schaltungen bessere Ergebnisse erzielen, da ein aktueller Zustand des Leistungshalbleiterschalters den Einschaltvorgang beeinflussen kann. Zudem kann die Steuerschaltung der **Fig. 1** ohne externe Steueranschluss-Widerstände auskommen.

Nachdem im Zusammenhang mit **Fig. 1** eine beispielhafte Steuerschaltung vorgestellt wurde, sollen in der Folge anhand der Kurven der **Fig. 2** zu den Phasen des Einschaltvorgangs des Leistungshalbleiterschalters erläutert werden, die die Steuerschaltung detektiert (und in Antwort auf die Detektion den Strom an den Steuereingang des Leistungshalbleiterschalters variiert).

**Fig. 2** zeigt fünf idealisierte und beispielhafte Kurven. Die oberste Kurve 202 zeigt einen Kollektor-Emitter-Strom (I_{CE}) eines Leistungshalbleiterschalters, die zweite Kurve 204 eine Kollektor-Emitter-Spannung (V_{CE}) 204. In der dritten Kurve 214 ist der Verlauf einer Gate-Spannung (V_{G}) (d.h. der Spannung an dem Steueranschluss des IGBTs) schematisch aufgetragen. Die vierte Kurve 206 illustriert einen beispielhaften Verlauf eines Stroms (I_{G}), der von der variablen Stromquelle in den Steuereingang des Leistungshalbleiterschalters gespeist wird. Zuletzt ist in der untersten Kurve 216 ein beispielhaftes Steuersignal (U_{CMD}) für das Schalten des Leistungshalbleiterschalters.

Wie in **Fig. 2** aufgetragen, kann der Einschaltvorgang des Leistungshalbleiterschalters in verschiedene Phasen (A0, A, B und C) eingeteilt werden. Der Leistungshalbleiterschalter befindet sich jeweils für eine bestimmte Zeitdauer in einer Phase. In jeder dieser Phasen hat der Leistungshalbleiterschalter einen bestimmten Zustand. Die Länge und Ausprägung der Phasen hängt unter anderem von den Parametern des Leistungshalbleiterschalters, den Parametern der Steuerschaltung und der Last sowie den Betriebsparametern ab. Wie bereits oben beschrieben, sind die hierin beschriebenen Steuerschaltungen dazu ausgelegt, eine aktuelle Phase des Einschaltvorgangs zu erkennen und basierend auf dieser Erkenntnis den variablen Steuerstrom anzupassen.

Die in **Fig. 2** gezeigten Kurven illustrieren das Einschaltverhalten eines IGBT. Allerdings zeigen auch andere Halbleiterschalter ein zumindest teilweise ähnliches Einschaltverhalten. So können auch im Einschaltverhalten eines Leistungs-MOSFET oder eines Leistungs-Bipolartransistors verschiedene Phasen identifiziert werden. Somit können die hierin beschriebenen Steuerschaltungen auch für andere Leistungshalbleiterschalter eingesetzt werden.

Des Weiteren ist es nicht zwingend, dass die Steuerschaltung die in **Fig. 2** gezeigten vier Phasen A0, A, B, C detektiert und in Antwort auf die Detektion den Strom variiert. Vielmehr können in einigen Beispielen auch nur eine Auswahl (zum Beispiel zwei oder drei) der in **Fig. 2** gezeigten Phasen detektiert werden. In weiteren Beispielen kann die Aufteilung der Phasen von der in **Fig. 2** gezeigten Aufteilung abweichen. So kann in einigen Steuerschaltungen ein Übergang zwischen einer ersten und einer zweiten Phase an einem anderen Punkt als in **Fig. 2** gezeigt passieren. Auch in diesem Beispiel kann jedoch eine hierein beschriebene Steuerschaltung einen Strom, der in den Steuereingang des Leistungshalbleiterschalters induziert wird, in Antwort auf die jeweils aktuelle Phase des Einschaltvorgangs variieren.

Nun soll der in **Fig. 2** gezeigte beispielhafte Verlauf der Steuersignale einer Steuerschaltung diskutiert werden, die in einem geschlossenen Regelkreis anhand der detektierten Phasen des Einschaltvorgangs eines Leistungshalbleiterschalters den Strom an den Steuereingang (I_{G}) variiert, um den Leistungshalbleiterschalter einzuschalten.

Der Einschaltvorgang beginnt zum Zweitpunkt t0 mit einem Zustandswechsel des Steuersignals U_{CMD} (im Bespiel der **Fig. 2** von einem niedrigen auf einen hohen Spannungspegel). Damit signalisiert eine Steuereinheit des Leistungshalbleiterschalters, dass dieser eingeschaltet werden soll. Die Phasendetektionsschaltung kann diesen Zustandswechsel in dem Steuersignal (U_{CMD}) detektieren. Mit dem Zustandswechsel beginnt eine erste Phase A0 des Einschaltvorgangs. In dem Beispiel von **Fig. 2** wird in der Phase A0 ein konstanter Strom (I_{G}) in den Steuereingang des Leistungshalbleiterschalters eingeleitet (wie in Kurve 206 zu sehen).

In der ersten Phase leitet der Leistungshalbleiterschalter noch nicht (der Kollektor-Emitter-Strom (I_{CE}) ist ungefähr Null). Daher beleibt die Kollektor-Emitter-Spannung (V_{CE}) auf ihrem (hohen) Pegel, den sie während des ausgeschalteten Zustands des Leistungshalbleiterschalters hat. Der Verlauf der Steuereingangsspannung (V_{G}) (Gate-Emitter-Spannung) wird bestimmt durch einen Ladevorgang verschiedener Kapazitäten in dem Leistungshalbleiterschalter. Zum Beispiel können im Falle eines IGBT verschiedene Kapazitäten zwischen Gate und Source des MOSFET-Steuerkopfs auftreten (zum Beispiel eine Oxidkapazität, eine Kapazität der Verarmungszone, eine Kapazität zwischen einer Gate-Elektrode und der Emitter-Elektrode und so weiter). Diese Kapazitäten werden durch den an den Steuereingang angelegten Strom in der Phase A0 geladen. In der Folge steigt die Spannung am Steuereingang des Leistungshalbleiterschalters mit einer Zweitkonstante an, die durch die internen Kapazitäten des Leistungshalbleiterschalters bestimmt wird.

Eine zweite Phase des Einschaltvorgangs des Leistungshalbleiterschalters beginnt an dem Zeitpunkt t1, an dem der IGBT zu leiten beginnt. Das passiert, wenn die Steuerspannung V_{G} eine Schwellspannung des MOSFETs des IGBTs erreicht. In der Folge steigt der Kollektor-Emitter-Strom (I_{CE}) stark an (in dieser Phase liegt an dem eine hohe Kollektor-Emitter-Spannung (V_{CE}) an, daher wird der Anstieg des Kollektor-Emitter-Stroms (I_{CE}) durch die Stromsteilheit im Sättigungsbereich des IGBT bestimmt). Die Kollektor-Emitter-Spannung (V_{CE}) nimmt noch nicht stark ab (z.B. da eine Freilaufdiode des IGBT noch keine Spannung aufnehmen kann). Die Steuereingangsspannung (V_{G}) nimmt weiterhin zu mit einer durch die Kapazitäten des IGBT bestimmten Rate.

Den Beginn der zweiten Phase A kann die Phasendetektionsschaltung anhand der Steuereingangsspannung (V_{G}) detektieren. Zum Beispiel kann die Phasendetektionsschaltung ausgelegt sein, den Beginn der zweiten Phase A zu detektieren, wenn die Steuereingangsspannung (V_{G}) einen vorbestimmten Schwellwert überschreitet. Einige Beispiele dazu sind weiter unten aufgeführt. Wie bereits erwähnt, kann die Phasendetektion auch basierend auf anderen Signalen erfolgen. So ändert sich, wie in **Fig. 2** zu sehen, am Zeitpunkt t1 die Charakteristik der Kollektor-Emitter-Spannung (V_{CE}) und des Kollektor-Emitter-Stroms (I_{CE}). Folglich kann in anderen Beispielen eine Phasendetektionsschaltung anhand der Kollektor-Emitter-Spannung (V_{CE}) oder des Kollektor-Emitter-Stroms (I_{CE}) den Beginn der zweiten Phase A erkennen.

In Antwort auf eine Detektion des Beginns der zweiten Phase A verändert die variable Stromquelle der Steuerschaltung einen Pegel des Stroms, der in den Steuereingang des Leistungshalbleiterschalters geleitet wird. Im Bespiel der **Fig. 2** wird der Strom, der in den Steuereingang des Leistungshalbleiterschalters geleitet wird, stufenweise von seinem Wert in der ersten Phase A0 reduziert (zum Beispiel in drei oder in vier Stufen). Die Länge der einzelnen Stufen kann vorbestimmt und auf den jeweiligen Leistungshalbleiterschalter angepasst sein. Dazu kann die Steuerschaltung eine vorbestimmte Menge von vom Benutzer wählbaren Verzögerungen definieren. Alternativ kann eine Länge der einzelnen Phasen in Antwort auf das Erreichen von Schwellspannungen durch die Steuereingangsspannung (V_{G}) eingestellt werden. In manchen Bespielen wird ein Strompegel in einer letzten Teilphase der zweiten Phase A entsprechend einer Nenn-Energie des Leistungshalbleiterschalters ausgewählt. In **Fig. 2** wird der Strom, der in den Steuereingang des Leistungshalbleiterschalters geleitet wird, stufenweise reduziert. In einem Beispiel kann die Länge der Stufen so ausgewählt sein, dass ein Übergang in die letzte Teilphase der zweiten Phase A bei Normalbetrieb dann erfolgt, wenn der Laststrom durch den Leistungshalbleiterschalter eine Pegel erreicht, der einem Pegel des Laststroms während des Miller-Plateaus des Einschaltvorgangs entspricht. In anderen Bespielen kann der Strom auch kontinuierlich reduziert werden.

Die in **Fig. 2** gezeigte stufenweise Reduktion Stroms, des der in den Steuereingang des Leistungshalbleiterschalters geleitet wird, kann eine Erhöhung der Stromsteilheit des Kollektor-Emitter-Stroms (I_{CE}) des Leistungshalbleiterschalters bewirken. Als Folge dessen wird ein Maximalwert des Kollektor-Emitter-Stroms (I_{CE}) früher erreicht als in Schaltungen, die nicht die stufenweise Reduktion des Steuereingangs-Stroms einsetzen. Das kann dazu führen, dass eine Verlustenergie während des Einschaltvorgangs reduziert wird.

Eine dritte Phase B des Einschaltvorgangs beginnt, wenn der Kollektor-Emitter-Strom (I_{CE}) des Leistungshalbleiterschalters seinen Maximalwert erreicht (zum Zeitpunkt t2 in **Fig. 2**). In der Folge nimmt die Freilaufdiode des IGBT Spannung auf, die Kollektor-Emitter-Spannung (V_{CE}) sinkt entsprechend und der Kollektor-Emitter-Strom (I_{CE}) fällt auf einen konstanten Laststromwert ab. Wie in **Fig. 2** erkennbar, kann der Beginn der dritten Phase auch anhand der Kollektor-Emitter-Spannung (V_{CE}) oder dem Kollektor-Emitter-Strom (I_{CE}) detektiert werden.

Den Beginn der dritten Phase kann die Phasendetektionsschaltung der Steuerschaltung in Antwort darauf detektieren, dass die Steuereingangsspannung (V_{G}) den Peak erreicht. In Antwort auf das Erkennen des Beginns der dritten Phase B variiert die Steuerschaltung erneut den Pegel des in den Steuereingang eingeleiteten Stroms (I_{G}). In einem Bespiel erhöht die Steuerschaltung den Pegel des Stroms (I_{G}) auf einen Wert zwischen dem Wert aus der letzten Teilphase der zweiten Phase A und dem Wert (oder dem kleinsten der Werte) der ersten Phase A0. Der Strom, der in den Steuereingang fließt (I_{G}), entlädt in der dritten Phase B eine interne Kapazität des Leistungshalbleiterschalters. Bedingt durch das schnelle Abfallen der Kollektor-Emitter-Spannung (V_{CE}) und durch die Zunahme der internen Kapazitäten des Leistungshalbleiterschalters verläuft die Steuereingangsspannung (V_{G}) in dieser Phase im Wesentlichen flach.

Wie in Fig. 2 gezeigt, kann die Steuerschaltung den in den Steuereingang eingeleiteten Strom (I_{G}) auch in der dritten Phase B in verschiedenen Teilphasen variieren. So hat im Beispiel von **Fig. 2** der Strom (I_{G}) zunächst einen konstanten Wert, bevor zum Zeitpunkt t3 eine ansteigende Steuereingangsspannung (V_{G}) mit einem fallenden Strom (I_{G}) einhergeht.

Zum Zeitpunkt t4 beginnt eine vierte und letzte Phase C des Einschaltvorgangs. Die Kollektor-Emitter-Spannung (V_{CE}) ist so stark gefallen, dass der IGBT in seinen aktiven Bereich gelangt. Der Kollektor-Emitter-Strom (I_{CE}) hat seinen Nennwert im eingeschalteten Zustand erreicht. Die Steuereingangsspannung (V_{G}) strebt ihrem stationären Wert entgegen. Der Beginn der vierten Phase C kann von der Phasendetektionsschaltung erkannt werden, wenn die Steuereingangsspannung (V_{G}) einen weiteren (zweiten) vorbestimmten Schwellwert überschreitet.

In Antwort auf die Detektion des Beginns der vierten Phase C kann die Steuerschaltung erneut einen Pegel des Stroms (I_{G}), der in den Steuereingang geleitet wird, variieren. Im Bespiel von **Fig. 2** setzt die Steuerschaltung den Strom (I_{G}) auf einen konstanten Pegel. Dieser ist geringer als die Pegel des variablen Stroms (I_{G}) in allen vorangehenden Phasen A0, A, B. In einem Bespiel ist der Strom (I_{G}) so gewählt, dass er einem Minimalstrom (gegebenenfalls unter Berücksichtigung eines vorbestimmten Sicherheitsabstands) entspricht, um den IGBT in Betrieb zu halten. Diese Auswahl kann bei Verwendung mancher Topologien der variablen Stromquelle vorteilhaft sein, da diese Schaltungen während der gesamten Einschaltdauer des IGBT Leistung aufnehmen. Ein möglichst geringer Pegel des Stroms (I_{G}) kann somit die Verlustleistung der Steuerschaltung während der Einschaltdauer des IGBT reduzieren.

In den letzten Abschnitten wurde erläutert, wie eine bespielhafte Steuerschaltung einen an den Steuereingang gelieferten Strom im Verlauf des Einschaltvorgangs eines Leistungshalbleiterschalters variiert. Wie bereits erwähnt, kann die Steuerschaltung auch nur einen Teil der vier Phasen der **Fig. 2** detektieren und den Strom (I_{G}) dementsprechend variieren (z.B., die nur die erste, zweite und dritte Phase A0, A, B, nur die zweite, dritte und vierte Phase A, B, C oder nur die zweite und vierte Phase A, C).

Im Zusammenhang mit **Fig. 2** wurde in den letzten Abschnitten eine beispielhafte Steuerschaltung funktional beschrieben. In den nächsten Abschnitten werden im Zusammenhang mit den **Figuren 3 bis 5** beispielhafte Schaltungen besprochen, um die Steuerschaltung zu implementieren.

Wie bereits anhand von **Fig. 1** erläutert, kann die Steuerschaltung eine variable Stromquelle und eine Phasendetektionsschaltung umfassen. In **Fig. 3** ist eine beispielhafte Ausgestaltung dieser beiden Komponenten zu sehen. Die variable Stromquelle 102, 104 umfasst eine Stromquellen-Schaltung 102 sowie eine Mehrzahl von Halbleiterschaltern (Q₁) 104. Die Phasendetektionsschaltung 118 umfasst verschiedene Komponenten, um zu detektieren, in welcher Phase des Einschaltvorgangs sich der Leistungshalbleiterschalter gerade befindet. Beide Komponenten (die variable Stromquelle 102, 104 und die Phasendetektionsschaltung 118) werden in der Folge genauer erklärt werden.

Die variable Stromquelle 102, 104 wird zuerst diskutiert werden. Wie in **Fig. 3** zu sehen, weist die variable Stromquelle 102, 104 in einem Bespiel mehrere parallele Stromquellen-Stufen auf. Jede dieser Stufen umfasst einen Stromverstärker und einen Halbleiterschalter, der einen Strom an den Steuereingang G des Leistungshalbleiterschalters liefern kann. Die Ausgangströme der parallelen Stromquellen-Stufen können so gewählt sein, dass durch Ein- und Ausschalten verschiedene von der Steuerschaltung benötigte Strompegel zur Verfügung stehen. In dieser Weise kann ein variabler Strom während des Einschaltvorgangs an den Steuereingang G des Leistungshalbleiterschalters angelegt werden.

In einem Bespiel können die Stromverstärker 102 dazu ausgelegt sein, ein Phasensignal (U_{PS}) 120 und ein Referenzstromsignal (U_{CS}) zu empfangen. Im Weiteren wird davon ausgegangen, dass das Referenzstromsignal (U_{CS}) ein Referenzstrom ist. In anderen Beispielen kann es eine Referenzspannung sein. Die variable Stromquelle 102, 104 kann in Antwort auf das Phasensignal (U_{PS}) 120 ein oder mehrere parallele Stromquellen-Stufen aktivieren. In der Folge wird ein vorbestimmter Strom (in Abhängigkeit von dem Ausgangstrom der ein oder mehr Stromquellen-Stufen) in den Steuereingang geleitet. Die Stromquellen-Stufen können unterschiedliche oder gleiche Ausgangströme liefern. In **Fig. 3** sind vier parallele Stromquellen-Stufen skizziert. Allerdings kann die Anzahl der Stromquellen-Stufen in anderen Beispielen unterschiedlich sind (z.B. zwei (oder mehr), drei oder mehr als vier). Die Anzahl und die Ausgangsströme der Stromquellen-Stufen kann so ausgewählt sein, dass eine variable Stromquelle die Mehrzahl an benötigten Ausgangströmen bereitstellen kann (durch Aktivierung einer oder mehrerer Stromquellen-Stufen).

Das Phasendetektionssignal kann dabei Informationen enthalten, dass der Leistungshalbleiterschalter in eine der oben im Zusammenhang mit **Fig. 2** diskutierten Phasen (Phase A0, A, B oder C) eingetreten ist. Die variable Stromquelle 102, 104 kann Ausgangströme mit den Eigenschaften (Pegeln und Zeitdauern) liefern, wie sie ebenfalls im Zusammenhang mit **Fig. 2** erläutert wurden.

Um die jeweiligen Ausgangsströme bereitzustellen, kann jede der parallelen Stromquellen-Stufen den Referenzstrom mit einem vorbestimmten Faktor verstärken. In einem Beispiel wird der Referenzstrom aus einem Bereich der Steuerschaltung mit niedrigeren Spannungspegel (zum Beispiel 4 bis 6 V) empfangen. Auf der anderen Seite sind die Halbleiterschalter 104 der variablen Stromquelle 102, 104 zwischen den Steuereingang G des Leistungshalbleiterschalters und eine Referenzspannung eines Bereichs der Steuerschaltung mit höherem Spannungspegel V1 (zum Bespiel 24 bis 26 V) geschaltet. Somit leiten die Halbleiterschalter 104 den variablen Ausgangstrom der variablen Stromquelle 102, 104 aus dem der Bereich der Steuerschaltung mit höherem Spannungspegel V1 in den Steuereingang. In einem Bespiel erzielt die variable Stromquelle 102, 104 die oben beschriebene Umsetzung von dem Bereich mit niedrigem Spannungspegel in den Bereich mit höherem Spannungspegel ohne Verwendung von Level-Shiftern.

In einem Beispiel enthält jeder der parallelen Stromquellen-Stufen eine Stromspiegel-Schaltung, die den Referenzstrom auf den jeweiligen Ausgangsstrom verstärkt. In einem Bespiel kann jede Stromspiegel-Schaltung mehrere MOSFET-Halbleiterschalter umfassen, die bemessen sind, um den jeweiligen Ausgangsstrom bereit zu stellen. Zusätzlich können die Halbleiterschalter einer oder mehr der parallelen Stromquellen-Stufen kaskodiert angeordnet sein. Das kann einen Ausgangswiderstand der Stromquellen-Stufen verbessern. Zusätzlich oder alternativ können die Halbleiterschalter in jeder der parallelen Stromquellen-Stufen von unterschiedlicher Bauart sein. So können in einem Bespiel Halbleiterschalter mit niedriger Nennspannung und Halbleiterschalter mit höherer Nennspannung verwendet werden.

Die Verwendung von Stromspiegel-Schaltungen zur Erzeugung des Ausgangstroms in der variablen Stromquelle kann verschiedene Vorteile haben. Zum einen kann eine Transkonduktanz der Schaltung durch Injektion eines gewünschten Stroms variiert werden. Zudem kann die variable Transkonduktanz ermöglichen, einen geschlossenen Regelkreis beim Einschalten des Leistungshalbleiterschalters zu realisieren. Des Weiteren können in den Stromspiegel-Schaltungen Prozess- und Temperaturschwankungen (zumindest teilweise) kompensiert werden. Zudem kann eine Ansprechzeit der variablen Stromquelle reduziert werden (zum Beispiel im Vergleich zu einer Schaltung mit einer Inverter-Kette).

Wie bereits erwähnt, kann variable Stromquelle 102, 104 eine Mehrzahl an Halbleiterschaltern umfassen. In einem Beispiel können die Halbleiterschalter integriert sein mit einem separaten Source-Well (im Falle von MOSFETs). Das kann eine Variation des Ausgangstroms mit der Temperatur reduzieren.

In anderen Bespielen können aktive Bereiche der Halbleiteschalter (in den Stromquellen-Stufen) als ganzzahlige Vielfache eines Referenz-Halbleiterschalters gewählt werden. Das kann eine Streuung des Ausgangsstroms durch eine prozessbedingte Variation bei der Herstellung reduzieren.

Im Zusammenhang mit der **Fig. 2** wurde bereits erläutert, dass die variable Stromquelle innerhalb einer Phase einen Ausgangsstrom mit verschiedenen Pegeln zur Verfügung stellen kann (siehe zum Beispiel die zweite Phase A in **Fig. 2**). In einem Bespiel können die zwei oder mehr Stufen des Ausgangstroms in Antwort auf Ausgangspulse einer Puls-Erzeugungsschaltung generiert werden. Diese kann, beginnend mit dem Zeitpunkt, zu dem das Phasensignal (U_{PS}) den Beginn einer bestimmten Phase signalisiert, ein oder mehr Pulse vorbestimmter Länge erzeugen. Die variable Stromquelle kann von einem Zustandswechsel jedes der Pulse ab einen vorbestimmten Strom erzeugen. Somit kann die Puls-Erzeugungsschaltung die Zeitdauer der verschiedenen Teil-Phasen ohne Verwendung eines Oszillators oder ähnlichem erreichen. In **Fig. 2** wurde eine mehrstufige Ausgestaltung des variablen Stroms nur für die zweite Phase A diskutiert. Allerdings kann diese Technik (unter Einsatz einer Puls-Erzeugungsschaltung) auch in anderen Phasen des Einschaltvorgangs verwendet werden.

In den vorhergehenden Abschnitten wurden einige Bespiele für die Implementierung der variablen Stromquelle 102, 104 diskutiert. In den folgenden Abschnitten sollen, wieder am Beispiel der **Fig. 3** **und** **5****,** verschiedene Aspekte bezüglich der Implementierung der Phasendetektionsschaltung 118 besprochen werden. Im Zusammenhang mit **Fig. 2** wurde bereits besprochen, welche Phasen des Einschaltvorgangs des Leistungshalbleiterschalters die Phasendetektionsschaltung detektieren kann.

Die Phasendetektionsschaltung 118 der **Fig. 3** enthält eine Zustands-Schaltung 302, eine Peak-Timing-Detektionsschaltung 304, mehrere Komparatoren 310, 312, 314 und mehrere optionale Level-Shifter 316, 318, 320. Mit diesen Komponenten kann die Phasendetektionsschaltung ermitteln, in welcher Phase des Einschaltvorgangs sich der Leistungshalbleiterschalter gerade befindet.

In der **Fig. 3** empfängt die Phasendetektionsschaltung 118 Steuereingangsspannung (V_{G}) und das Steuersignal (U_{CMD}). Basierend auf diesen Signalen kann die Phasendetektionsschaltung 118 ermitteln, welche Phase des Einschaltvorgangs gerade durchlaufen wird. Wie bereits erwähnt, kann anstatt der Steuereingangsspannung (V_{G}) auch ein anderes Signal, das das Einschaltverhalten des Leistungshalbleiterschalters charakterisiert (zum Beispiel die Kollektor-Emitter-Spannung (V_{CE}) oder der Kollektor-Emitter-Strom (V_{CE})) verwendet werden. Wie weiter unten im Zusammenhang mit **Fig. 5** erläutert wird, können zudem zusätzlich zu der Steuereingangsspannung (V_{G}) ein oder mehrere weitere andere Signale, die das Einschaltverhalten des Leistungshalbleiterschalters charakterisiert (zum Beispiel die Kollektor-Emitter-Spannung (V_{CE}) oder der Kollektor-Emitter-Strom (V_{CE})) verwendet werden.

Die Phasendetektionsschaltung erzeugt ein Phasendetektionssignal (U_{PS}) 120, das die jeweilige Phase (und/oder einen Übergang zwischen zwei Phasen) anzeigt. In manchen Bespielen kann das Phasensignal (U_{PS}) 120 mehrere Kanälen beinhalten, die jeweils das Vorliegen einer bestimmten Phase oder den Zeitpunkt eines Übergangs zwischen zwei bestimmten Phasen anzeigen. Wie weiter oben beschrieben, wird das Phasensignal (U_{PS}) 120 von der variablen Stromquelle 102, 104 empfangen, die in Antwort auf das Phasensignal (U_{PS}) 120 einen entsprechenden Strom ausgibt.

Die Phasendetektionsschaltung 118 ist dazu ausgelegt, zwei unterschiedliche Charakteristika der Steuereingangsspannung (V_{G}) zu detektieren: Zum einen kann die Phasendetektionsschaltung 118 detektieren, wenn die Steuereingangsspannung (V_{G}) einen oder mehrere vorbestimmte Schwellwerte überschreitet (oder unterschreitet). Zum anderen kann die Phasendetektionsschaltung 118 detektieren, wann die Steuereingangsspannung (V_{G}) einen Peak aufweist. Im Zusammenhand mit **Fig. 2** wurde bereits ausgeführt, dass diese beiden Detektionsschritte zum Erkennen von mehreren Phasenübergängen während des Einschaltvorgangs des Halbleiterschalters ausreichen können.

Zunächst wird nun auf die mehreren Komparatoren 310, 312, 314 eingegangen, mit deren Hilfe die Phasendetektionsschaltung 118 feststellen kann, wenn die Steuereingangsspannung (V_{G}) einen bestimmten Schwellwert überschreitet. Im Bespiel von **Fig. 3** ist die Vergleichsschaltung in der Art eines Flash-ADC ausgelegt (d.h., die mehreren Komparatoren 310, 312, 314 arbeiten parallel). Die Steuereingangsspannung (V_{G}) wird in den parallelen Komparatoren 310, 312, 314 jeweils mit einer Referenzspannung TH1, TH2, THN verglichen. Somit kann die Phasendetektionsschaltung 118 ermitteln, wann ein bestimmter Grenzwert TH1, TH2, THN überschritten wird. Im Bespiel der **Fig. 2** kann für die Erkennung des Phasenübergangs von der ersten in die zweite Phase (A0→A) und für die Erkennung eines Übergangs von der dritten in die vierte Phase (B→C) ein Vergleich der Steuereingangsspannung (V_{G}) mit einem Schwellwert nötig sein. Diese Vergleiche werden jeweils durch einen der mehreren parallelen Komparatoren 310, 312, 314 durchgeführt.

Im Bespiel von **Fig. 3** werden zudem mehrere der parallelen Komparatoren 310, 312, 314 auch für die Detektion eines Zeitpunkts eingesetzt, an dem die Steuereingangsspannung (V_{G}) den Peak erreicht. Diese Vergleichswerte können also zur Detektion des Übergangs von der zweite in die dritte Phase (A→B) gemäß **Fig. 2** verwendet werden. Das wird weiter unten im Zusammenhang mit der Peak-Detektionsschaltung 304 weiter erläutert.

In einem Bespiel können die Referenzspannungen TH1, TH2, THN mit Bezug auf die erste Referenzspannung (V₁) generiert werden. Zum Bespiel kann die erste Referenzspannung (V₁) durch einen oder mehrere Spannungsteiler (z.B. einen Spannungsteiler pro Komparator 310, 312, 314) auf die gewünschte Referenzspannungen TH1, TH2, THN heruntergeteilt werden.

Die Vergleichsschaltung in der Art eines Flash-ADC der **Fig. 3** kann vorteilhaft sein, wenn die Steuereingangsspannung (V_{G}) zur Detektion der Phasen des Eingangssignals verwendet wird, da die Vergleichsschaltung in der Art eines Flash-ADC der **Fig. 3** eine hohe Eingangsimpedanz aufweisen können. Der Steuereingang G kann einen hohen Ausgangswiderstand haben, was den Einsatz einer Detektionsschaltung mit niedrigem Eingangswiderstand erschwert (da sonst Ladung vom Steuereingang abfließen könnte, was das zu messende Signal stören könnte).

In einem Bespiel sind ein oder mehrere der Komparatoren 310, 312, 314 als gefalteter Transkonduktanzverstärker mit Push-Pull-Ausgangsstufe ausgestaltet. In einem weiteren Bespiel sind ein oder mehrere der Komparatoren 310, 312, 314 als gelatchte Schaltung mit Push-Pull-Ausgangsstufe ausgestaltet. Beide Alternativen können einen großen Gleichtaktbereich aufweisen, was zur Detektion eines Zeitpunkts, an dem die Steuereingangsspannung (V_{G}) den Peaks erreicht, nötig sein kann (die Spannung am Peak der Steuereingangsspannung (V_{G}) kann zum Bespiel 96% der ersten Referenzspannung V₁ betragen). Die Lösung mit einer gelatchten Schaltung mit Push-Pull-Ausgangsstufe kann gegenüber der Lösung mit einem Transkonduktanzverstärker mit Push-Pull-Ausgangsstufe in diesem Fall eine geringere Baugröße der Ausgangsstufe und eine höhere Anstiegsgeschwindigkeit aufweisen.

Da im Bespiel von **Fig. 3** die Zustands-Schaltung 302 in einem Bereich mit niedrigerer Spannung angeordnet ist, werden die Ausgangssignale der Komparatoren 310, 312, 314 durch entsprechende Level-Shifter 316, 318, 320 heruntergesetzt. Die resultierenden Signale CO1, CO2, CON können von der Zustands-Schaltung 302 und der Peak-Detektionsschaltung 304 empfangen und weiterverarbeitet werden.

In den folgenden Abschnitten wird nun auf eine beispielhafte Peak-Timing-Detektionsschaltung 304 näher eingegangen.

In einem Beispiel kann die Peak-Timing-Detektionsschaltung 304 die Ausgangssignale CON, CON-1...CO3 von mehreren der Komparatoren 310, 312, 314 als Eingangssignal empfangen. Die Peak-Timing-Detektionsschaltung 304 kann dazu ausgelegt sein, einen Peak in der Steuereingangsspannung (V_{G}) zu erkennen, wenn die Steuereingangsspannung (V_{G}) alle Schwellspannungen einer Teilmenge der Komparatoren 310, 312, 314 (zum Beispiel einem oder zwei Komparatoren), die die Ausgangssignale CON, CON-1...CO3 liefern, überschritten hat und die Schwellspannung des Komaparators der Teilmenge mit der höchsten Schwellspannung wieder unterschritten hat. In diesem Fall signalisiert die Peak-Timing-Detektionsschaltung 304 mittels eines Detektionssignals (U_{DT}) 306 an die Zustands-Schaltung 302, dass die Steuereingangsspannung (V_{G}) einen Peak erreicht hat. In diesem Beispiel erfolgt die Peak-Detektion unabhängig von einer Höhe des Spannungsmaximums der Steuereingangsspannung (V_{G}).

In manchen Fällen weist die Steuereingangsspannung (V_{G}) keinen ausgeprägten Peak. Auch kann die oben vorgestellte Peak-Timing-Detektionsschaltung durch Oszillationen während dem Übergang von der zweiten Phase A in die dritte Phase B gestört werden. Daher kann eine Peak-Timing-Detektionsschaltung 304 (zusätzlich oder alternative zu der oben besprochenen Peak-Timing-Detektionsschaltung) eine weitere Schaltung umfassen. Eine beispielhafte weitere Schaltung wird in der Folge besprochen.

Auch die weitere bespielhafte Peak-Timing-Detektionsschaltung hat die Ausgangssignale einer Teilmenge der Komparatoren 310, 312, 314 als Eingangssignale. Zusätzlich wird für jeden der Teilmenge der Komparatoren 310, 312, 314 ein weiteres Signal erzeugt, dass um eine vorbestimmte Verzögerung verzögert wird. Die verzögerten und die unverzögerten Ausgangssignale jedes Komparators 310, 312, 314 werden auf ein ODER-Gatter beaufschlagt. Damit wird jeweils das am frühesten auftretende Signal für jede Schwellspannung bestimmt. Der Zeitpunkt des Peaks wird durch eine UND-Verknüpfung der Ausgangssignal des ODER-Gatters ermittelt. Dabei können die einzelnen Verzögerungen für den jeweiligen Typ des Leistungshalbleiterschalters ausgewählt werden (z.B. unter Berücksichtigung einer Steilheit eines Anstiegs der Steuereingangsspannung (V_{G}) nach Beginn eines Einschaltvorgangs).

In den vorhergehenden Abschnitten wurde erläutert, wie die Phasendetektionsschaltung verschiedene Merkmale der Steuereingangsspannung (V_{G}) detektieren kann. In den folgenden Abschnitten wird erklärt, wie aus den Ausgangssignalen der Komparatoren 310, 312, 314, dem Steuersignal (U_{CMD}) 116 und dem Ausgangsignal der Peak-Timing-Detektionsschaltung 304 detektiert werden kann, welche Phase der Einschaltvorgang gerade durchläuft.

Diese Funktion nimmt die Zustands-Schaltung 302 wahr, deren Funktion in Zusammenhang mit **Fig. 4** erklärt wird. Wie in **Fig. 4** zu sehen ist, kann die Zustands-Schaltung 302 eine Zustandsmaschine umfassen. Im Bespiel der **Fig. 4** kann die Zustands-Schaltung 302 erkennen, in welchem von vier Phasen des Einschaltvorgangs sich der Leistungshalbleiterschalter gerade befindet. Die vier Phasen entsprechen den vier Phasen, die im Zusammenhang mit **Fig. 2** besprochen wurden (d.h. Phasen A0, A, B und C).

Wie bereits erwähnt, kann ein Beginn des Einschaltvorgangs basierend auf dem Steuersignal (U_{CMD}) 116 für den Halbleiterschalter detektiert werden. In einem Bespiel kann der Beginn eines Einschaltvorgang des Leistungshalbleiterschalters detektiert werden, wenn das Steuersignal (U_{CMD}) 116 eine steigende oder fallende Flanke aufweist. In Antwort auf den Zustandswechsel des Steuersignals (UCMD) 116 kann die Zustands-Schaltung 302 erkennen, dass der Leistungshalbleiterschalter in die Phase 402 (A0) des Einschaltvorgangs eingetreten ist.

Des Weiteren kann die Zustands-Schaltung 302 basierend auf einem Ausganssignal (CO₁) eines ersten Komparators entscheiden, ob ein Übergang von der ersten Phase 402 (A0) in die zweite Phase 404 (A) stattgefunden hat. Wenn die Steuereingangsspannung (V_{G}) die Schwellspannung des ersten Komparators überschreitet hat das Ausgangsignal CO₁ des ersten Komparators einen ersten Zustand (z.B. einen hohen Pegel). Wenn die Steuereingangsspannung (V_{G}) die Schwellspannung des ersten Komparators unterschreitet hat das Ausgangsignal CO₁ des ersten Komparators einen ersten Zustand (z.B. einen niedrigen Pegel *̅C̅O̅*̅1̅)*.* In manchen Bespielen muss der Komparator einen bestimmten Zustand für eine vorbestimmte Zeitdauer halten, bevor ein Phasenwechsel detektiert wird.

In manchen Bespielen kann der jeweilige Komparator (zum Beispiel der erste Komparator für den Übergang von Phase A0 auf Phase A) eine vorbestimmte Zweit nach einer Feststellung des Phasenübergangs abgeschaltet werden (z.B. 20ns bis 80ns). Dadurch kann eine Leistungsaufnahme der Schaltung verringert werden.

Wie bereist besprochen, kann ein Übergang in eine dritte Phase (B) 408 basierend auf einem Ausgangsignal 406 (das dem Detektionssignal (U_{DT}) 306 entspricht) einer Peak-Timing-Detektionsschaltung erkannt werden. Wenn dieses Ausgangsignal 406 signalisiert, dass die Steuereingangsspannung (V_{G}) einen Peak (oder ein Maximum) erreicht hat, ändert die Zustands-Schaltung 302 die aktuelle Phase auf die zweite Phase (B) 406. Wie bereits erwähnt, kann das Ausgangsignal 406 der Peak-Detektionsschaltung einen Zeitpunkt des Peaks der Steuereingangsspannung (V_{G}) basierend auf dem Ausgangsignal einer Mehrzahl von Komparatoren bestimmen. Auch diese können eine vorbestimmte Zeitdauer (z.B. 20ns bis 80ns) nach dem Erkennen des Phasenübergangs von der zweiten in die dritte Phase (A→B) abgeschaltet werden.

Der Übergang von Phase B 408 (der dritten Phase) zur Phase C 410 (der vierten Phase) kann in Reaktion auf das Ausgangssignal CO2 eines zweiten Komparators erfolgen. Damit kann die Zustands-Schaltung 302 erkennen, ob ein Übergang von der dritten Phase (B) 408 in eine vierte Phase (C) 410 stattgefunden hat. Wenn die Steuereingangsspannung (V_{G}) die Schwellspannung des zweiten Komparators überschreitet hat das Ausgangsignal CO₂ des zweiten Komparators einen ersten Zustand (z.B. einen hohen Pegel). Wenn die Steuereingangsspannung (V_{G}) die Schwellspannung des zweiten Komparators unterschreitet hat das Ausgangsignal CO2 des zweiten Komparators einen ersten Zustand (z.B. einen niedrigen Pegel *̅C̅O̅*̅2̅).

Das Eintreten in die vierte Phase (C) 410 ist der letzte Phasenübergang, den die Zustands-Schaltung 302 erkennt. In anderen Beispielen kann der Einschaltvorgang in mehr Phasen eingeteilt werden (z.B. fünf, sechs oder sieben oder mehr Phasen), die basierend auf dem Verlauf der Steuereingangsspannung (VG) detektiert werden können. In wieder anderen Bespielen kann der Einschaltvorgang in weniger Phasen eingeteilt werden (z.B. zwei oder drei), die basierend auf dem Verlauf der Steuereingangsspannung (V_{G}) detektiert werden können. In allen Fällen können Phasendetektionsschaltungen und variable Stromquellen der Art verwendet werden, wie sie weiter oben für den Fall von vier Phasen des Einschaltvorgangs diskutiert wurden.

Sobald der Eintritt in eine bestimmte Phase erkannt wurde, erzeugt die Zustands-Schaltung 302 ein entsprechendes Phasensignal (U_{PS}) 120. Dieses Phasensignal (U_{PS}) 120 kann dann, wie oben diskutiert, von einer variablen Stromquelle empfangen werden. Die variable Stromquelle kann wiederum einen für die jeweilige Phase vorbestimmten Ausgangsstrom (kontant oder variabel) an den Steuereingang des Leistungshalbleiterschalters leiten, um den Leistungshalbleiterschalter einzuschalten. Die vorhergehenden Abschnitte haben anhand von **Fig. 3** und von **Fig. 4** beispielhafte variable Stromquellen und Phasendetektionsschaltungen der Steuerschaltung diskutiert. In der Folge wird noch eine Variante dieser Schaltungen diskutiert werden. **Fig. 5** zeigt eine Alternative zu der Peak-Timing-Detektionsschaltung der **Fig. 3****,** um den Übergang von der zweiten Phase in die dritte Phase (A→B) zu erkennen (d.h., einen Zeitpunkt, zu dem ein Kollektor-Emitter-Strom (I_{CE}) ein Maximum aufweist). Die Phasenschaltung 118 der **Fig. 5** enthält eine Phasenübergangsschaltung 504, die ein auf der Kollektor-Emitter-Spannung (V_{CE}) basierendes Signal (V_{CEF}) 536 als Eingangssignal empfängt und basierend auf diesem Signal einen Phasenübergang detektiert.

Das auf der Kollektor-Emitter-Spannung (V_{CE}) basierendes Signal (V_{CEF}) 536 wird durch einen Filter 530 erzeugt, der eine Kapazität C₁ und ein resistives Element R₁ erhält, die zwischen einen Kollektoranschluss C und einen Emitteranschluss E des Leistungshalbleiterschalters gekoppelt sind.

In einem Bespiel kann eine Steuerschaltung eines IGBT eine Serienschaltung von parallel geschalteten Kapazitäten und resistiven Elementen umfassen, die an den Kollektor-Anschluss des Leistungshalbleiterschalters gekoppelt ist (beispielsweise, um eine aktive Klemmfunktion bereitzustellen). Der Filter 530 kann zwischen eine letzte Kapazität der Serienschaltung von parallel geschalteten Kapazitäten und resistiven Elementen und eine Referenz-Spannungspegel 112 gekoppelt werden.

Der Filter 530 kann dazu ausgelegt sein, eine Spannungsspitze zu erzeugen, wenn der Peak des Kollektor-Emitter-Stroms überschritten wurde. Dieses Signal (V_{CEF}) 536 wird an die Phasenübergangsschaltung 504 weitergeleitet. In der Phasenübergangsschaltung 504 kann in einem Bespiel aus dem Signal (V_{CEF}) 536 ein Zeitpunkt des Peaks des Kollektor-Emitter-Stroms (I_{CE}) ermittelt werden. Diese Information kann die Phasenübergangsschaltung 504 verwenden, um einen Phasenübergang von der zweiten Phase (A) in die dritte Phase (B) des Einschaltvorgangs zu detektieren. Ein entsprechendes Detektionssignal (U_{DT}) 506 kann wiederum an die Zustands-Detektions-Schaltung 502 übermittelt werden.

In einem Beispiel kann die Phasenübergangsschaltung 504 das Signal (V_{CEF}) 536 verstärken und das verstärkte Signal auf einem Differenzverstärker beaufschlagen. Das resultierende Signal kann am Zeitpunkt des Peaks des Kollektor-Emitter-Stroms (I_{CE}) eine fallende Flanke haben und somit den Phasenübergang von der zweiten in die dritte Phase (A→B) indizieren. Zum Bespiel kann dazu die fallende Flanke des resultierenden Signals detektiert werden.

In einem Beispiel kann die Phasenübergangsschaltung 504 das Signal (V_{CEF}) 536 in drei Verstärkerstufen verstärkt werden. Zunächst kann ein Bufferverstärker die Ausgangsimpedanz des zu detektierenden Signals am V_{CE}-Knoten verringern. Danach kann eine nicht-invertierende Verstärkung und darauffolgend eine Differenzverstärkung des Signals erfolgen.

Die obige Beschreibung der dargestellten Beispiele der vorliegenden Erfindung, ist nicht erschöpfend oder beschränkt auf die Beispiele gemeint. Während spezifische Ausführungsformen und Beispiele für die Erfindung hierin zu Veranschaulichungszwecken beschrieben sind, sind verschiedene Modifikationen möglich, ohne von der vorliegenden Erfindung abzuweichen. Die spezifischen Beispiele für Spannung, Strom, Frequenz, Leistung, Bereichswerte, Zeiten etc., sind nur illustrativ, so dass die vorliegende Erfindung auch mit anderen Werten für diese Größen umgesetzt werden kann.

Diese Modifikationen können an Beispielen der Erfindung im Lichte der obigen detaillierten Beschreibung durchgeführt werden. Die Begriffe, die in den folgenden Ansprüchen verwendet werden, sollten nicht so ausgelegt werden, als dass die Erfindung auf die spezifischen Ausführungsformen, die in der Beschreibung und den Ansprüchen offenbart sind, beschränkt ist. Die vorliegende Beschreibung und die Figuren sind als veranschaulichend und nicht als einschränkend anzusehen.

## Patentansprüche

1. Steuerschaltung (100) zum Anschalten eines Leistungshalbleiterschalters (108), umfassend:
einen Eingang, der dazu ausgelegt ist, ein Signal (114) zu empfangen, das das Einschaltverhalten des Leistungshalbleiterschalters charakterisiert, wobei das Signal, das ein Einschaltverhalten des Leistungshalbleiterschalters charakterisiert eine Steuereingangsspannung (114) ist, die an einem Steuereingang des Leistungshalbleiterschalters anliegt, die Kollektor-Emitter-Spannung des Leistungshalbleiterschalters ist, oder der Kollektor-Emitter-Strom des Leistungshalbleiterschalters ist;
eine Phasendetektionsschaltung (118), die dazu ausgelegt ist, zwei oder mehr Phasen im Verlauf des Einschaltvorgangs des Leistungshalbleiterschalters basierend auf dem Signal, das ein Einschaltverhalten des Leistungshalbleiterschalters charakterisiert zu detektieren und ein Phasendetektionssignal (120) zu erzeugen, das signalisiert, welche der zwei oder mehr Phasen der Leistungshalbleiterschalter aktuell durchläuft; und
eine variable Stromquelle (102), die dazu ausgelegt, in Antwort auf das Phasendetektionssignal einen Strom mit variabler Stromstärke an den Steuereingang des Leistungshalbleiterschalters zu liefern, um den Leistungshalbleiterschalter einzuschalten,
wobei die Steuerschaltung dazu ausgelegt ist, die variable Stromquelle in Antwort auf das Signal, das das Einschaltverhalten des Leistungshalbleiterschalters charakterisiert, in einem geschlossenen Regelkreis zu regeln, und **dadurch gekennzeichnet, dass** die Steuerschaltung dazu ausgelegt ist, innerhalb einer der Phasen, die von dem Phasendetektionssignal (120) signalisiert wurden, die variable Stromquelle zu verändern, sodass die variable Stromquelle den Strom an den Steuereingang mit verschiedenen Pegeln mit vorbestimmten Längen zur Verfügung stellt.

2. Steuerschaltung gemäß Anspruch 1, wobei die Phasendetektionsschaltung die zwei oder mehr Phasen im Verlauf eines Einschaltvorgangs anhand von charakteristischen Merkmalen des Signals, das ein Einschaltverhalten des Leistungshalbleiterschalters charakterisiert erkennt.

3. Steuerschaltung gemäß einem der Ansprüche 1 bis 2, wobei die Phasendetektionsschaltung (118) ein oder mehrere Komparatoren (310, 312, 314, 510, 512, 514) enthält, wobei jeder der ein oder mehreren Komparatoren dazu ausgelegt ist, das Signal, das ein Einschaltverhalten des Leistungshalbleiterschalters charakterisiert mit einem von einem oder mehr Referenzsignalen zu vergleichen und wobei die Phasendetektionsschaltung Übergänge zwischen ein oder mehrerer der Phasen im Verlauf eines Einschaltvorgangs des Leistungshalbleiterschalters detektiert, wenn das das Signal, das ein Einschaltverhalten des Leistungshalbleiterschalters charakterisiert ein jeweiliges Referenzsignal übersteigt.

4. Steuerschaltung gemäß einem der Ansprüche 1 bis 3, wobei die Phasendetektionsschaltung eine Peak-Timing-Detektionsschaltung (304) umfasst, die dazu ausgelegt ist, einen Zeitpunkt eines Peaks in dem Signal, das ein Einschaltverhalten des Leistungshalbleiterschalters charakterisiert zu erkennen und wobei die Phasendetektionsschaltung dazu ausgelegt ist, einen Übergang zwischen zwei Phasen zu detektieren, wenn das Signal, das das Einschaltverhalten des Leistungshalbleiterschalters charakterisiert den Peak erreicht.

5. Steuerschaltung gemäß einem der Ansprüche 1 bis 3, wobei die Phasendetektionsschaltung dazu ausgelegt ist, mindestens vier Phasen im Verlauf des Einschaltvorgangs des Leistungshalbleiterschalters zu detektieren.

6. Steuerschaltung gemäß einem der Ansprüche 1 bis 5, wobei die variable Stromquelle mehrere parallele Treiber-Stufen beinhaltet.

7. Steuerschaltung gemäß Anspruch 6, wobei jede der mehreren Treiber -Stufen dazu ausgelegt ist, einen vorbestimmten Eingangsstrom um einen bestimmten Faktor zu verstärken.

8. Steuerschaltung gemäß Anspruch 7, wobei die Steuerschaltung einen Bereich mit erstem Spannungspegel und einen Bereich mit zweitem Spannungspegel beinhaltet, wobei der zweite Spannungspegel niedriger als der erste Spannungspegel ist und wobei ein Eingangsstrom von einer Stromquelle (102, 104) in dem Bereich mit niedrigerem Spannungspegel geliefert wird.

9. Steuerschaltung gemäß einem der Ansprüche 6 bis 8, wobei die Treiber-Stufen Stromspiegel-Schaltungen umfassen.

10. Steuerschaltung gemäß einem der Ansprüche 1 bis 9, wobei der Strom der an den Steuereingang des Leistungshalbleiterschalters geliefert wird, einen ersten Pegel in einer ersten Phase im Verlauf des Einschaltvorgangs des Leistungshalbleiterschalters hat, wobei der Strom einen zweiten Pegel im Verlauf einer zweiten Phase im Verlauf des Einschaltvorgangs des Leistungshalbleiterschalters hat und wobei der Strom einen dritten Pegel in einer dritten Phase im Verlauf des Einschaltvorgangs des Leistungshalbleiterschalters hat, wobei der dritte Pegel niedriger als der erste und höher als der zweite Pegel liegt.

11. Steuerschaltung gemäß einem der Ansprüche 1 bis 10, wobei die Phasendetektionsschaltung ein oder mehrere Level-Shifter (316, 318, 320, 516, 512, 5180) umfasst, die dazu ausgelegt sind, ein internes Signal, das von einem oder mehreren Komparatoren ausgegeben wird, von einem höheren Spannungspegel in der Steuerschaltung auf einen niedrigeren Spannungspegel, in der Steuerschaltung umzusetzen.

12. Steuerschaltung gemäß einem der Ansprüche 1 bis 11 wobei die zwei oder mehr Phasen im Verlauf eines Einschaltvorgangs des Leistungshalbleiterschalters basierend auf einer Steuereingangsspannung ist, die an dem Steuereingang des Leistungshalbleiterschalters anliegt und zusätzlich basierend auf einer Spannung, die über den Leistungsanschlüssen des Leistungshalbleiterschalters anliegt detektiert werden.

13. Steuerschaltung gemäß einem der Ansprüche 1 bis 12, wobei eine Transkonduktanz der Steuerschaltung im Verlauf des Einschaltvorgangs des Leistungshalbleiterschalters verändert wird.

14. Verfahren zum Einschalten eines Leistungshalbleiterschalters, umfassend:
empfangen eines Signals (114), das das Einschaltverhalten des Leistungshalbleiterschalters (108) charakterisiert, wobei das Signal, das ein Einschaltverhalten des Leistungshalbleiterschalters charakterisiert eine Steuereingangsspannung (114) ist, die an einem Steuereingang des Leistungshalbleiterschalters anliegt, die Kollektor-Emitter-Spannung des Leistungshalbleiterschalters ist, oder der Kollektor-Emitter-Strom des Leistungshalbleiterschalters ist;
detektieren von zwei oder mehr Phasen in dem Signal, das ein Einschaltverhalten des Leistungshalbleiterschalters charakterisiert, wobei regeln eines Stroms an einen Steuereingang eines Leistungshalbleiterschalters umfasst:
erzeugen eines Phasendetektionssignals, das signalisiert, welche der zwei oder mehr Phasen der Leistungshalbleiterschalter aktuell durchläuft;
variieren eines Stroms an den Steuereingang des Leistungshalbleiterschalters in Antwort auf das Phasendetektionssignal; und
regeln des Stroms an den Steuereingang des Leistungshalbleiterschalters in einem geschlossenen Regelkreis basierend auf dem Signal, das ein Einschaltverhalten des Leistungshalbleiterschalters charakterisiert, um den Leistungshalbleiterschalter einzuschalten;
**dadurch gekennzeichnet, dass** das Regeln das Zurverfügungstellen des Stroms an den Steuereingang mit verschiedenen Pegeln mit vorbestimmten Längen innerhalb einer der Phasen, die von dem Phasendetektionssignal (120) signalisiert wurde, umfasst.

## Claims

1. A control circuit (100) for switching on a power semiconductor switch (108), comprising:
an input that is designed to receive a signal (114) that characterizes the switch-on behavior of the power semiconductor switch;
a phase detection circuit (118) that is designed to detect two or more phases in the course of the switch-on operation of the power semiconductor switch, based on the signal that characterizes a switch-on behavior of the power semiconductor switch, and to generate a phase detection signal (120) that indicates which of the two or more phases the power semiconductor switch is passing through at the moment; and
a variable current source (102) that is designed to supply a current having variable current intensity to a control input of the power semiconductor switch in response to the phase detection signal, in order to switch on the power semiconductor switch,
wherein the control circuit is designed to control the variable current source in a closed control loop as a response to the signal that characterizes the switch-on behavior of the power semiconductor switch, and
wherein the control circuit is designed to change the variable current source within one of the phases that has been indicated by the phase detection signal (120), so that the variable current source provides the current to the control input at various levels having predetermined lengths.
wherein the signal that characterizes a switch-on behavior of the power semiconductor switch
a) is a control input voltage (114) that is present at the control input of the power semiconductor switch,
b) is the collector emitter voltage of the power semiconductor switch, or
c) is the collector emitter current of the power semiconductor switch.

2. The control circuit according to Claim 1, wherein the phase detection circuit identifies the two or more phases in the course of a switch-on operation, based on characteristic features of the signal that characterizes a switch-on behavior of the power semiconductor switch.

3. The control circuit according to one of Claims 1 to 2, wherein the phase detection circuit (118) contains one or more comparators (310, 312, 314, 510, 512, 514), each of the one or more comparators being designed to compare the signal that characterizes a switch-on behavior of the power semiconductor switch to one of one or more reference signals, and wherein the phase detection circuit detects transitions between one or more of the phases in the course of a switch-on operation of the power semiconductor switch when the signal that characterizes a switch-on behavior of the power semiconductor switch exceeds a particular reference signal.

4. The control circuit according to one of Claims 1 to 3, wherein the phase detection circuit includes a peak timing detection circuit (304) that is designed to recognize a point in time of a peak in the signal that characterizes a switch-on behavior of the power semiconductor switch, and the phase detection circuit is designed to detect a transition between two phases when the signal that characterizes the switch-on behavior of the power semiconductor switch reaches the peak.

5. The control circuit according to one of Claims 1 to 3, wherein the phase detection circuit is designed to detect at least four phases in the course of the switch-on operation of the power semiconductor switch.

6. The control circuit according to one of Claims 1 to 5, wherein the variable current source contains multiple parallel driver stages.

7. The control circuit according to Claim 6, wherein each of the multiple driver stages is designed to amplify a predetermined input current by a certain factor.

8. The control circuit according to Claim 7, wherein the control circuit contains a region having a first voltage level and a region having a second voltage level, the second voltage level being lower than the first voltage level, and an input current being supplied by a current source (102, 104) in the region having the lower voltage level.

9. The control circuit according to one of Claims 6 to 8, wherein the driver stages include current mirror circuits.

10. The control circuit according to one of Claims 1 to 9, wherein the current that is supplied to the control input of the power semiconductor switch has a first level in a first phase in the course of the switch-on operation of the power semiconductor switch, the current having a second level in a second phase in the course of the switch-on operation of the power semiconductor switch, and the current having a third level in a third phase in the course of the switch-on operation of the power semiconductor switch, wherein the third level is lower than the first level and higher than the second level.

11. The control circuit according to one of Claims 1 to 10, wherein the phase detection circuit includes one or more level shifters (316, 318, 320, 516, 512, 5180) that are designed to convert an internal signal that is output by one or more comparators from a higher voltage level in the control circuit to a lower voltage level in the control circuit.

12. The control circuit according to one of Claims 1 to 11, wherein the two or more phases are detected in the course of a switch-on operation of the power semiconductor switch, based on a control input voltage that is present at the control input of the power semiconductor switch, and additionally based on a voltage that is present via the power terminals of the power semiconductor switch.

13. The control circuit according to one of Claims 1 to 12, wherein a transconductance of the control circuit is changed in the course of the switch-on operation of the power semiconductor switch.

14. A method for switching on a power semiconductor switch, comprising:
receiving a signal (114) that characterizes the switch-on behavior of the power semiconductor switch (108), wherein the signal that characterizes a switch-on behavior of the power semiconductor switch is a control input voltage (114) that is present at a control input of the power semiconductor switch, is the collector emitter voltage of the power semiconductor switch, or is the collector emitter current of the power semiconductor switch;
detecting two or more phases in the signal that characterizes a switch-on behavior of the power semiconductor switch, wherein controlling a current at a control input of a power semiconductor switch includes:
generating a phase detection signal that indicates which of the two or more phases the power semiconductor switch is passing through at the moment;
varying a current at the control input of the power semiconductor switch in response to the phase detection signal: and
controlling the current at the control input of the power semiconductor switch in a closed control loop, based on the signal that characterizes a switch-on behavior of the power semiconductor switch, in order to switch on the power semiconductor switch;
**characterized in that** the control includes providing the current to the control input at various levels having predetermined lengths within one of the phases that has been indicated by the phase detection signal (120).

## Revendications

1. Circuit de commande (100) destiné à activer un commutateur à semi-conducteur de puissance (108), le circuit de commande comprenant :
une entrée conçue pour recevoir un signal (114) caractérisant le comportement de mise en circuit du commutateur à semi-conducteur de puissance ;
un circuit de détection de phase (118) conçu pour détecter au moins deux phases au cours de processus de mise en circuit du commutateur à semi-conducteur de puissance sur la base du signal caractérisant un comportement de mise en circuit du commutateur à semi-conducteur de puissance et pour générer un signal de détection de phase (120) qui indique dans laquelle des au moins deux phases le commutateur à semi-conducteur de puissance se trouve actuellement ; et
une source de courant variable (102) conçue pour fournir un courant d'intensité variable à une entrée de commande du commutateur à semi-conducteur de puissance en réponse au signal de détection de phase afin de mettre en circuit le commutateur à semi-conducteur de puissance,
le circuit de commande étant conçu pour réguler la source de courant variable dans une boucle de régulation fermée en réponse au signal caractérisant le comportement de mise en circuit du commutateur à semi-conducteur de puissance, et
le circuit de commande étant conçu pour modifier la source de courant variable dans l'une des phases qui a été indiquée par le signal de détection de phase (120) de sorte que la source de courant variable fournit le courant à l'entrée de commande à divers niveaux et à des longueurs prédéterminées. le signal caractérisant un comportement de mise en circuit du commutateur à semi-conducteur de puissance étant
a) une tension d'entrée de commande (114) appliquée à l'entrée de commande du commutateur à semi-conducteur de puissance,
b) la tension collecteur-émetteur du commutateur à semi-conducteur de puissance, ou
c) le courant collecteur-émetteur du commutateur à semi-conducteur de puissance [page 21, lignes 6 à 13].

2. Circuit de commande selon la revendication 1, le circuit de détection de phase détectant les au moins deux phases au cours d'un processus de mise en circuit sur la base de caractéristiques du signal caractérisant un comportement de mise en circuit du commutateur à semi-conducteur de puissance.

3. Circuit de commande selon l'une des revendications 1 à 2, le circuit de détection de phase (118) contenant au moins un comparateur (310, 312, 314, 510, 512, 514), chacun des comparateurs étant conçu pour comparer le signal, qui caractérise un comportement de mise en circuit du commutateur à semi-conducteur de puissance, à au moins un signal de référence, et le circuit de détection de phase détectant les transitions entre au moins une des phases au cours d'un processus de mise en circuit du commutateur à semi-conducteur de puissance lorsque le signal caractérisant un comportement de mise en circuit du commutateur à semi-conducteur de puissance dépasse un signal de référence particulier.

4. Circuit de commande selon l'une des revendications 1 à 3, le circuit de détection de phase comprenant un circuit de détection d'instant de crête (304) conçu pour détecter l'instant d'une crête dans le signal, caractérisant un comportement de mise en circuit du commutateur à semi-conducteur de puissance et le circuit de détection de phase est étant conçu pour détecter une transition entre deux phases lorsque le signal caractérisant le comportement de mise en circuit du commutateur à semi-conducteur de puissance atteint la crête.

5. Circuit de commande selon l'une des revendications 1 à 3, le circuit de détection de phase étant conçu pour détecter au moins quatre phases au cours du processus de mise en circuit du commutateur à semi-conducteur de puissance.

6. Circuit de commande selon l'une des revendications 1 à 5, la source de courant variable contenant plusieurs étages de commande en parallèle.

7. Circuit de commande selon la revendication 6, chacun des plusieurs étages de commande étant conçu pour amplifier un courant d'entrée prédéterminé d'un certain facteur.

8. Circuit de commande selon la revendication 7, le circuit de commande contenant une zone ayant un premier niveau de tension et une zone ayant un deuxième niveau de tension, le deuxième niveau de tension étant inférieur au premier niveau de tension et un courant d'entrée étant fourni par une source de courant (102, 104) dans la zone ayant le plus faible niveau de tension.

9. Circuit de commande selon l'une des revendications 6 à 8, les étages de commande comprenant des circuits à miroir de courant.

10. Circuit de commande selon l'une des revendications 1 à 9, le courant fourni à l'entrée de commande du commutateur à semi-conducteur de puissance présentant un premier niveau dans une première phase au cours du processus de mise en circuit du commutateur à semi-conducteur de puissance, le courant ayant un deuxième niveau dans une deuxième phase au cours du processus de mise en circuit du commutateur à semi-conducteur de puissance, et le courant ayant un troisième niveau dans une troisième phase au cours du processus de mise en circuit du commutateur à semi-conducteur, le troisième niveau étant inférieur au premier niveau et supérieur au deuxième niveau.

11. Circuit de commande selon l'une des revendications 1 à 10, le circuit de détection de phase comprenant au oins un registre à décalage de niveau (316, 318, 320, 516, 512, 5180) conçu pour faire passer un signal interne, qui est émis par au moins un comparateur, d'un niveau de tension plus élevé dans le circuit de commande à un niveau de tension moins élevé dans le circuit de commande.

12. Circuit de commande selon l'une des revendications 1 à 11, les au moins deux phases étant détectées au cours d'un processus de mise en circuit du commutateur à semi-conducteur de puissance sur la base d'une tension d'entrée de commande appliquée à l'entrée de commande du commutateur à semi-conducteur de puissance, et en outre sur la base d'une tension appliquée aux bornes de puissance du commutateur à semi-conducteur de puissance.

13. Circuit de commande selon l'une des revendications 1 à 12, une transconductance du circuit de commande étant modifiée au cours du processus de mise en circuit du commutateur à semi-conducteur de puissance.

14. Procédé de mise en circuit d'un commutateur à semi-conducteur de puissance, le procédé comprenant les étapes suivantes :
recevoir un signal (114) caractérisant le comportement de mise en circuit du commutateur à semi-conducteur de puissance (108), le signal caractérisant un comportement de mise en circuit du commutateur à semi-conducteur de puissance étant une tension d'entrée de commande (114) appliquée à l'entrée de commande du commutateur à semi-conducteur de puissance, la tension collecteur-émetteur du commutateur à semi-conducteur de puissance ou le courant collecteur-émetteur du commutateur à semi-conducteur de puissance ;
détecter au moins deux phases dans le signal caractérisant un comportement de mise en circuit du commutateur à semi-conducteur de puissance, la régulation d'un courant à une entrée de commande d'un commutateur à semi-conducteur de puissance comprenant les étapes suivantes :
générer un signal de détection de phase qui indique dans laquelle des au moins deux phases le commutateur à semi-conducteur de puissance se trouve actuellement ;
faire varier un courant à l'entrée de commande du commutateur à semi-conducteur de puissance en réponse au signal de détection de phase ; et
réguler le courant à l'entrée de commande du commutateur à semi-conducteur de puissance dans une boucle de régulation fermée sur la base du signal caractérisant un comportement de mise en circuit du commutateur à semi-conducteur de puissance afin mettre en circuit le commutateur à semi-conducteur de puissance ;
**caractérisé en ce que** la régulation comprend la fourniture du courant à l'entrée de commande à divers niveaux et à des longueurs prédéterminées dans l'une des phases indiquées par le signal de détection de phase (120).
